# EUROPEAN PATENT APPLICATION

(11) **EP 1 890 525 A1**
(43) Date of publication of application: **20.02.2008**
(21) Application number: 07114252.5
(22) Date of filing: 13.08.2007
(51) Int. Cl.: H05K 7/14, H05K 7/20

(54) **Heat transferring guide for electronic cards**

(30) Priority: 14.08.2006 US 464397
(71) Applicant: HONEYWELL INC., Morristown, New Jersey 07962 (US)
(72) Inventor: Damien, Nicolas D., Safety Harbor, FL 34695 (US)
(74) Representative: Haley, Stephen

(57) **Abstract**

An electronic card heat transferring guide is provided. The system includes at least one first clamping member, at least one second clamping member and a plurality of attaching members. Each first clamping member has at least one clamping aperture. Moreover, each first clamping member has a first surface adapted to abut an inside surface of a chassis wall and a second surface adapted to abut an electronic card. Each second clamping member has at least one clamping aperture. Moreover, each second clamping member has a first surface adapted to abut the inside surface of the chassis wall and a second surface adapted to abut the electronic card. Each attaching member is adapted to engage an associated first and second clamping member through the chassis via associated clamping apertures in the respective first and second clamping members,

## Description

Electronic cards are essential to many devices. From home computers to missile guiding satellites, electronic cards must be kept in proper working order or they may cause their device to fail. One major problem confronting electronic cards is the dissipation of unwanted heat generated while operating. Almost every electronic card generates unwanted heat and must dissipate that heat in order to work effectively.

Often heat dissipation is accomplished via convection, by passing air over the surface of a card with a fan. In some situations, however, convection cooling is unavailable. One such situation occurs where air is difficult to move past the electronics because of, for example, tightly packed circuits. Another such situation occurs in space operations, because air is not present at all. In these situations, the only practical heat dissipation occurs through conduction. Conduction can be more difficult than convection, because conduction requires direct contact between two conducting surfaces in order to transfer the heat. In addition, the strength of the contact between the two surfaces can affect the heat transfer.

Generally, electronic cards are inserted into a master interconnect card, often referred to as a motherboard. Once inserted into the motherboard, the card must be secured in place and, if conduction is desired, the card must be put into contact with a conductive surface. Conventional devices have accomplished conduction with a guide structure that is integrated into the wall of a chassis which holds the motherboard and cards. The guide serves two purposes, both to secure the card and to conduct heat away from the card. The guides are integral with the chassis and thus, the contact between the cards and the guide is affected by the manufacturing tolerances of the parts. Also, it is difficult to provide effective force upon the card to ensure good contact with the guide.

For the reasons stated above, and for other reasons stated below which will become apparent to those skilled in the art upon reading and understanding the present specification, there is a need in the art for an improved guide for electronic cards that provides efficient thermal conduction.

The above-mentioned problems of current systems are addressed by embodiments of the present invention and will be understood by reading and studying the following specification. The following summary is made by way of example and not by way of limitation. It is merely provided to aid the reader in understanding some of the aspects of the invention. In one embodiment, an electronic card heat transferring guide is provided. The system includes at least one first clamping member, at least one second clamping member and a plurality of attaching members. Each first clamping member has at least one clamping aperture. Moreover, each first clamping member has a first surface adapted to abut an inside surface of a chassis wall and a second surface adapted to abut an electronic card. Each second clamping member has at least one clamping aperture. Moreover, each second clamping member has a first surface adapted to abut the inside surface of the chassis wall and a second surface adapted to abut the electronic card. Each attaching member is adapted to engage an associated first and second clamping member through the chassis wall via associated clamping apertures in the respective first and second clamping members, wherein tightening each respective attaching member draws the second surface of the first and second clamping members to abut the electronic card and the inside surface of the wall thereby securing the electronic card between the first and second clamping members in the chassis and providing a relatively efficient thermal conduit between the electronic card and the chassis.

In the Drawings:

The present invention can be more easily understood and further advantages and uses thereof more readily apparent, when considered in view of the detailed description and the following figures in which:

Figure 1 is a perspective view of a conventional electronic housing;

Figure 2A is a side view of a conventional electronic card guide with card and chassis;

Figure 2B is a side view of a conventional electronic card guide with card and chassis;

Figure 3is a side view of a conventional electronic card with motherboard;

Figure 4 is a perspective view of an electronic card guide with card and chassis of one embodiment of the present invention;

Figure 5 is a cross-sectional side view of an electronic card guide with card and chassis of one embodiment of the present invention;

Figure 6 is an interior exploded side view of an electronic card guide of one embodiment of the present invention;

Figure 7 is an exterior exploded side view of an electronic card guide of one embodiment of the present invention;

Figure 8 is a flow diagram illustrating an example of one method of implementing an embodiment of the present invention; and

Figure 9 is a flow diagram illustrating an example of one method of removing a card from the guide.

In accordance with common practice, the various described features are not drawn to scale but are drawn to emphasize specific features relevant to the present invention. Reference characters denote like elements throughout Figures and text.

In the following detailed description, reference is made to the accompanying drawings that form a part hereof, and in which is shown by way of illustration specific illustrative embodiments in which the device may be practiced. These embodiments are described in sufficient detail to enable those skilled in the art to practice the invention, and it is to be understood that other embodiments may be utilized and that logical, mechanical and electrical changes may be made without departing from the spirit and scope of the present invention. The following detailed description is, therefore, not to be taken in a limiting sense.

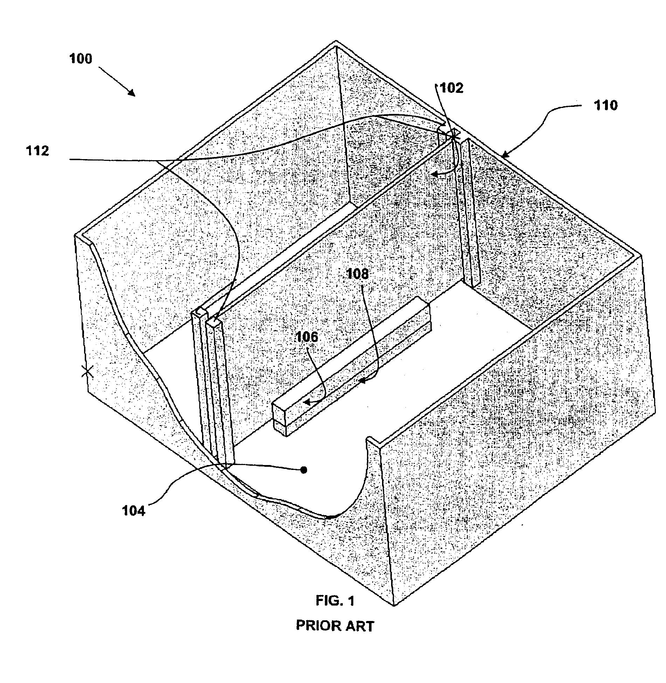

To aid in the understanding of the current invention, further background is provided in Figures 1-3. Figure 1 shows a perspective view of a conventional device 100 having an electronic card 102 and a motherboard 104. Electronic card 102 has an electrical connector 106 which is mated into a complementary electrical connector 108 in the motherboard 104. The card 102 is secured by a chassis 110 with integrated guides 112. Guide 112 may also conduct heat away from the card 102 and into the chassis 110.

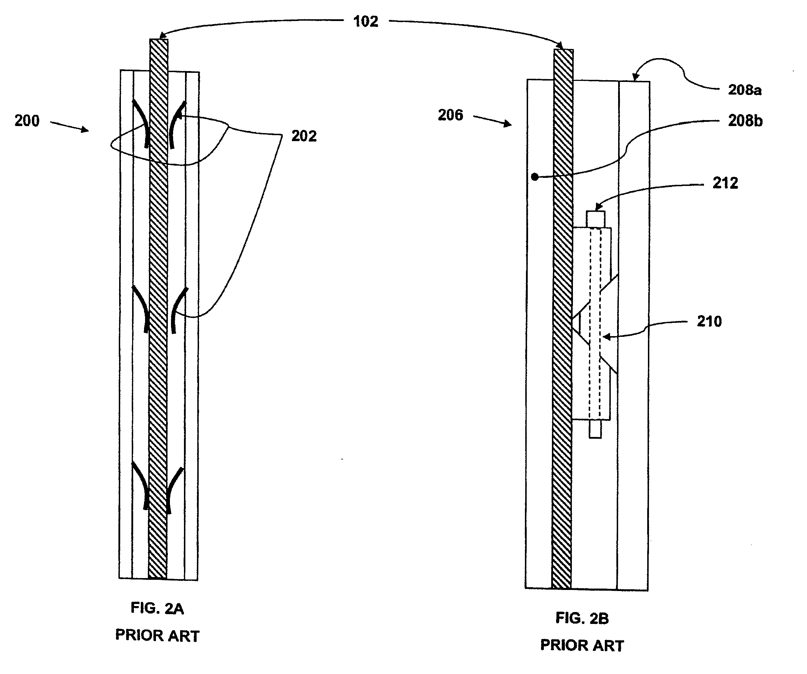

Figures 2A and 2B provide more detailed examples of conventional card guides such as guides 112 in FIG. 1. Guide 200 in FIG. 2A holds electronic card 102. Guide 200 has a plurality of spring elements 202, which secure card 102 in place by placing pressure on the card 102 through tension in the spring elements 202. This style of guide allows the card 102 to be secured relatively well despite manufacturing tolerances in the motherboard and chassis. Guide 200 does not, however, maximize heat transfer characteristics between the card 102 and the spring elements 202, because the spring elements 202 cannot provide significant contact pressure against the card 102.

Another style of card guide is shown in FIG. 2B. This style of guide is common in space applications where air is unavailable. Guide 206 has two rails 208a and 208b which are integral to the chassis 110. A wedge 210 has its pointed end attached to the electronic card 102 and its flat end parallel to a rail 208a. The wedge 210 contains a screw 212 which expands wedge 210 laterally when twisted. As wedge 210 expands, the flat end of the wedge 210 comes into contact with the rail 208a and forces the card 102 into contact with the other rail 208b.

The intent of this approach is to force the card 102 into contact with the stationary rail 208b. Then, heat generated by the circuit card can be conducted through the rail 208b and into the chassis 110. The heat conduction of card guide 206, however, is substantially affected by manufacturing tolerances in the electronic card 102, motherboard 104, connectors 106, 108, and the chassis 110. The variation in alignment of the rails 208a, 208b due to these tolerances reduces the uniformity of the pressure distribution and the contact area across the rail 208b. Thus the resulting heat transfer is less than optimal. Furthermore, guide 206 places stress on the mated electrical connectors 106, 108, because the connectors 106, 108 cannot move while the card 102 is forced sideways against the rail 208a. Another difficulty encountered with guide 208 is that the screw 212 tends to be long and narrow. A long and narrow screw is more subject to deflection along the length of the screw as it is tightened. For this reason, as the devices settle over time the torque on the screw 212 can be lost. Less torque on the screw 212 translates to less force pressing the card 102 against the rail 208a, and thus poorer heat transfer. This can require frequent manual retightening of the screw 212. The problem is magnified when the screw 212 is on a device that is orbiting in space 250 miles above the surface of the earth.

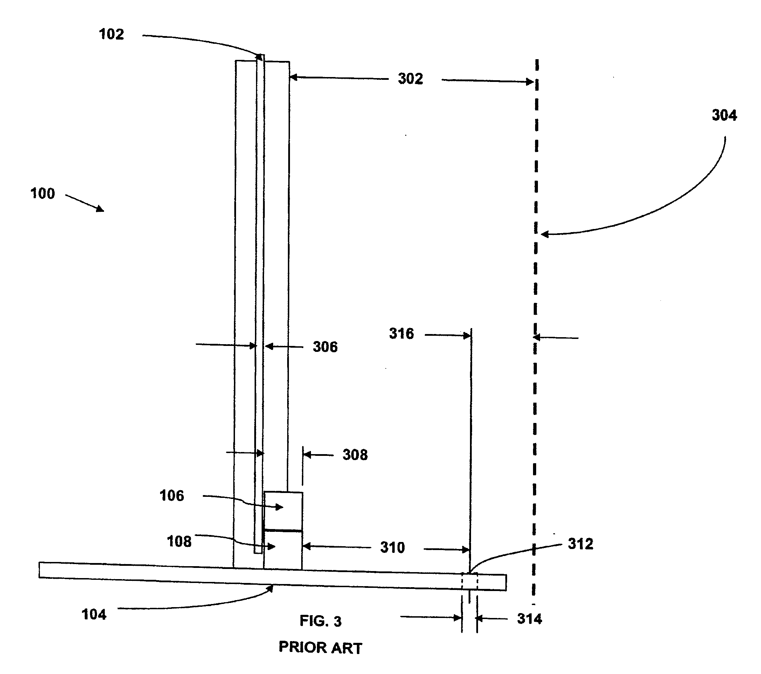

Figure 3 is a side-view of a conventional device 100 illustrating the tolerances that affect the alignment of the card 102. The card chassis dimension 302 is the distance between card 102 and a chassis feature 304 (e.g. guide 112). Ideally, the card chassis dimension 302 is minimized to allow for strong heat conduction and good contact between the card 102 and chassis feature 304. In reality, however, due to manufacturing tolerances inherent in any production assembly the card chassis dimension 302 is often larger than desired.

One such tolerance is the thickness 306 of the card 102. The variation of the thickness 306 of the card 102 directly affects the card chassis dimension 302. Likewise, the thickness 308 of the electrical connector 106 affects the card chassis dimension 302. The distance 310 between the mounting screw 312 on the motherboard 104 and the motherboard electrical connector 108 will cause the card 102 to vary relative to the chassis feature 304. Another tolerance factor is the diameter 314 of the mounting screw 312. Finally, any variation from the desired distance 316 between the mounting screw 312 and the chassis feature 304 will also affect card chassis dimension 302. At the greatest affect, every tolerance variation would occur in the same direction and the aggregate of the variations would cause a large change in the card chassis dimension 302.

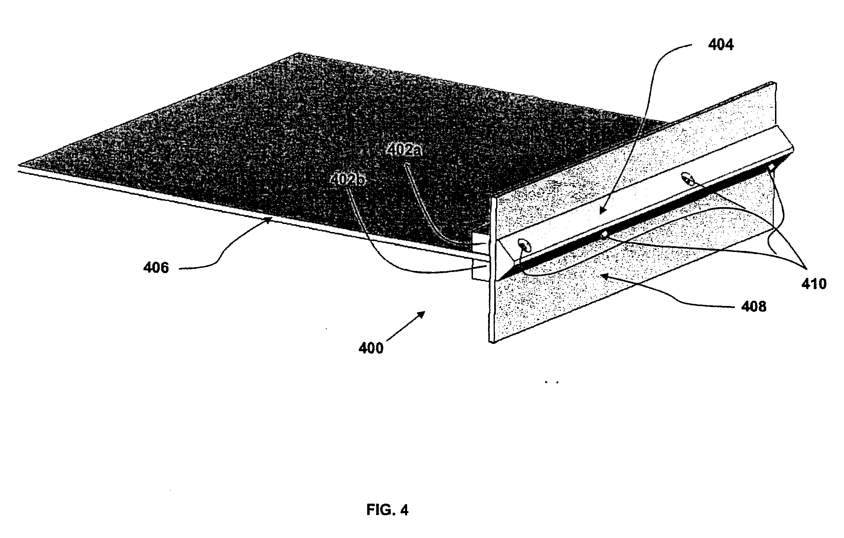

Figure 4 is a perspective view of one example of an electronic card guide 400 that minimizes the effect of the tolerances on the contact between the card and card guide of one embodiment of the present invention. Figure 4 illustrates a card guide 400 having two clamping members 402a, 402b, a securing bar 404 and attaching members 410. Guide 400 secures electronic card 406 in place and allows heat to transfer from card 406 to chassis 408. In one example, guide 400 and electronic card 406 are used in a device similar to FIG. 1 except that one or both of the guides of FIG. 1 would be replaced with guide 400. Referring back to FIG. 4, guide 400 is shown in the fully tightened position. In this position heat can be transferred from the card 406 through the clamping members 402a and 402b and into the chassis 404. In one example, card 406 uses two guides 400, one at each end of the card 406.

In one example, clamping members 402a, 402b are tightened against the card 406 and against the chassis 408 by the attaching members 410. In this example, four (4) attaching members 410 are used to secure the clamping members 402a, 402b with two (2) attaching members 410 going into each clamping member 402a, 402b. Alternatively, the number of attaching members 410 along the clamping members 402a, 402b may be increased in order to increase the clamping force of the clamping members 402a, 402b. As such, any number of attaching members 410 sufficient to secure the clamping members could be used.

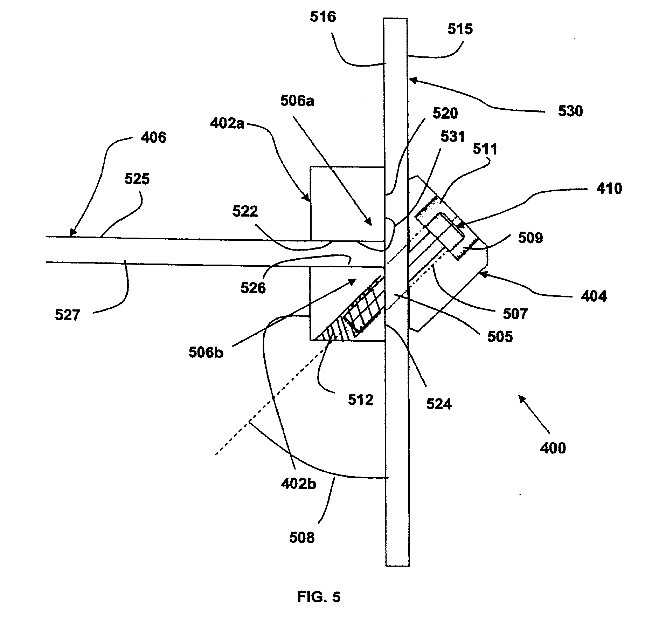

Referring now to Figure 5, a cross-sectional side view of a partial guide 400 of one embodiment is shown along with a card 406 and a chassis wall 530. As illustrated, the guide 400 includes a first clamping member 402a, a second clamping member 402b, a securing bar 404 and an attaching member 410. The first clamping member 402a includes a first thermally conductive surface 520 that abuts an inside surface 516 of the chassis wall 530. The first clamping member 402a further includes a second thermally conductive surface 522 that abuts a first side 525 of the card 406. The second clamping member 402b includes a first thermally conductive surface 524 that abuts the inside surface 516 of the chassis wall 530. The second clamping member 402b further includes a second thermally conductive surface 526 that abuts a second side 527 of the card 406. In embodiments, the first and second thermally conductive surfaces 520, 522, 524 and 526 of the first and second clamping members 402a and 402b adjoin each other at a 270° angle 531. The second clamping member 402b in this Figure illustrates that it contains a clamping aperture 512. In embodiments of the present invention, both the first and second clamping members 402a and 402b include a plurality of the clamping apertures 512. In one embodiment, the clamping apertures 512 have internal threads.

As further illustrated in Figure 5, the securing bar 404 has a surface that abuts an outside surface 515 of the chassis wall 530. The securing bar 404 also includes a securing aperture 507. In embodiments of the present invention, each securing bar 404 includes a plurality of the securing apertures similar to securing aperture 507. In the embodiment of Figure 5, a counter bore 509 is included about the securing aperture 507. The attaching member 410 is received in the securing aperture 507. In particular, the attaching member 410 is passed through the securing aperture 507 and a chassis aperture 505. The attaching member 410 is then attached to a respective clamping member 402a and 402b. In one embodiment, the attaching member 410 includes external threads that are sized to engage the internal threads of the clamping apertures 512 of the clamping members 402a and 402b. In other embodiments, other types of attaching devices sufficient to move and hold clamping members 402a and 402b into their respective positions is used.

In embodiments of the present invention, associated securing apertures 507, chassis apertures 505 and clamping apertures 512 are designed to line up at a select angle. In one embodiment, the angle 508 is 45° from the chassis wall 530. This is illustrated with regard chassis aperture 505 of clamping member 402b, chassis aperture 505 and securing aperture 507 in Figure 5. With the use of this angle, the attaching member 410 will draw the first thermally conductive surface 524 towards the inside wall surface 516 and the second thermally conductive surface 526 towards the second side 527 of the card 406 with an equal amount of force as the attaching member 410 is tightened into the clamping member 402b. Once the respective clamping members 402a and 402b are sufficiently drawn in by a respective attaching mechanism 402, a relatively efficient thermal connection is created between the card 406 the clamping members 402a and 402b and the chassis wall 408. Hence, a relatively efficient heat transfer from the card 406 can be achieved.

Conduction heat transfer between two solids is proportional to the amount of area in contact along the two solids and the contact pressure. Heat transfer, therefore, can be improved by having a clamping member shaped to precisely contact a large amount of the desired transfer surfaces. To better ensure uniform contact and maximum heat transfer between the respective first and second clamping members 402a and 402b, the card 406 and the chassis wall 530, the respective first and second surfaces 520, 522, 524 and 526 are relatively flat and drawn into corners 506a and 506b created by the card 406 and the chassis wall 530. In the embodiment of Figure 5, clamping members 402a, 402b are precisely rectangular. In other embodiments, the clamping member 402a, 402b are other shapes having first and second surfaces that are also relatively flat.

As stated above, tightening the clamping members 402a and 402b at a 45° angle allows each clamping member 402a and 402b to be simultaneously tightened with equal force against both the card 406 and the chassis wall 408. Thus, effective heat transfer from the card 406 to the chassis 408 is achieved. Alternatively, bolt 410 could be disposed at any angle sufficient to provide substantially equal force to the heat transfer surfaces. For example, if card 406 was positioned at a 30° angle, bolt 410 would be placed at a 15° angle.

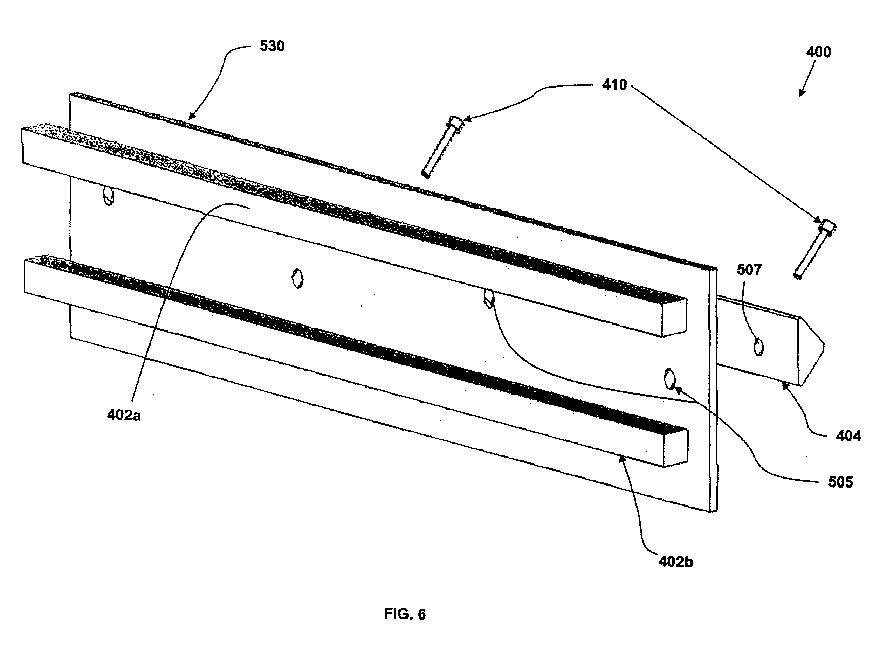

Referring now to Figure 6, one example of a guide 400 is shown in an interior exploded perspective view. In one example, chassis wall 530 has a plurality of unthreaded apertures 605 disposed at 45° angles such that a bolt 410 can fit through one of the apertures 505 and into a clamping member 402a, 402b. To allow for adjustability of the clamping members 402a, 402b, chassis apertures 505 have a diameter larger than the diameter of shaft of the bolt 410. The diameter of apertures 505 is sufficiently large to allow optimum positioning of one of the clamping members 402a, 402b prior to being fully tightened.

In one embodiment, securing bar 404 and both clamping members 402a, 402b are separate and discrete parts from the chassis wall 503. Since the guide 400 is separate, the guide 400 can be positioned after the card 406 has been mated in the motherboard. Positioning the guide 400 after mating with the motherboard eliminates the effect of most manufacturing tolerances of the chassis, motherboard, and card 410 on the alignment of the guide 400. This is because the tolerances of the assembly are irrelevant if the card guide 400 is not permanently attached to a wall 530 of the chassis. Regardless of whether the card 410 is located to the right or to the left, the card guide 400 can be located similarly to ensure a proper contact between the card 410 and the card guide 400. This results in more effective thermal conductivity between the card 410 and the card guide 400.

Additionally, the ability to position the guide 400 after mating of the card 406 and motherboard provides substantially equal force to each side of the card 402 during the tightening of the guide 400. Thus, there is less resulting force pushing the card in either direction. This translates to less stress placed on the mated connectors of the card 406 and motherboard. Additionally, this technique provides a more uniform pressure distribution across a heat transfer surface of the card 406.

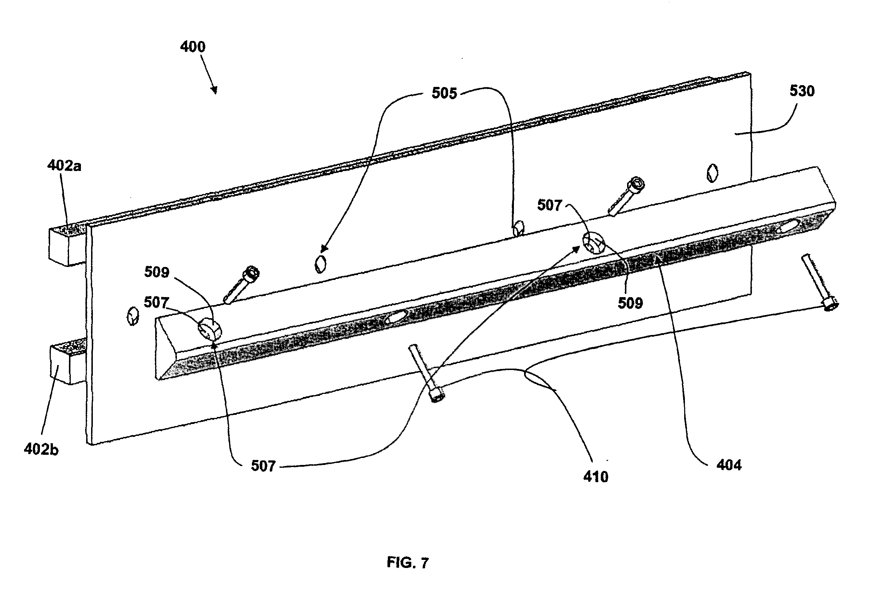

Referring now to Figure 7, one example of a guide 400 is shown in an exterior exploded perspective view. In this example, securing bar 404 is generally triangular, however, securing bar 404 can be any shape sufficient to allow the attaching members 410 to be effectively tightened. Alternatively, securing bar 404 need not be used. Securing bar 404 could be integral with a chassis wall 530, or non-existent in the situation that a fastener other than attaching members 410 is used to fasten clamping members 402a, 402b to the chassis wall 530.

In the embodiment that uses a counter bore 509 about the securing apertures 507, a relatively short attaching member 410 can be used. Relatively short attaching members 410 have less deflection over the length of the bolt 410 when torque asserted on a head of the attaching member. Thus, there is less chance of one of the bolt 410 loosening over time. Moreover, the counter bore 509 prevents the head of the attaching members 410 from sticking out past a surface of the securing bar 404.

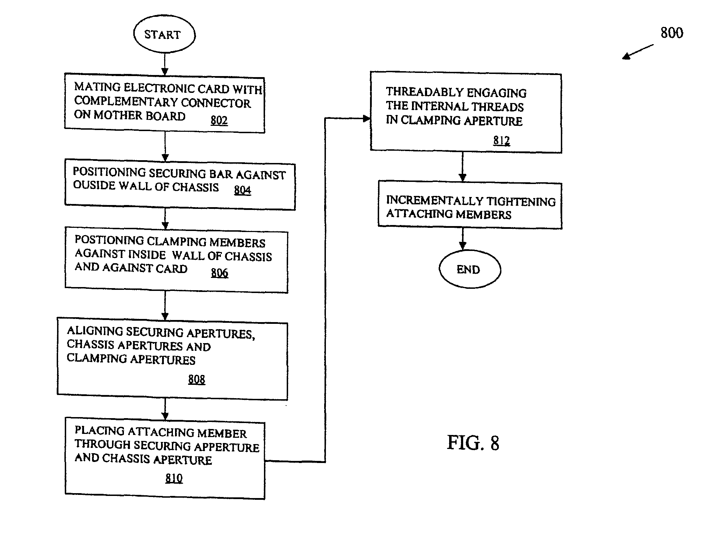

A flow diagram illustrating an example of one method of attaching a card in one embodiment of the present invention is shown in Figure 8. In operation, a connector on electronic card 406 is mated with a complementary connector on a motherboard (802). A Securing bar 404 is positioned against an outside surface 415 of a chassis wall 530 (804). Clamping members 402a and 402b are positioned against an inside surface 516 of the chassis wall 530 and against a respective side of the card 406 (806). Securing apertures 507 in the securing bar 404 are aligned with chassis apertures 505 in the chassis wall 530 and clamping apertures 512 in the respective clamping member 402a and 402b (808). Each attaching member is then placed through a respective securing aperture and chassis aperture (810). Attaching members 410 then threadably engage internal threads in respective clamping apertures 512 (812). Attaching members 410 are tightened to force clamping members 402a, 402b solidly into their respective corners 506a, 506b. In one embodiment, attaching members 410 are tightened incrementally and by a rotation, similar to tightening lug nuts on a vehicle wheel. In other words, each bolt 410 is tightened only to an incremental torque; then, once all attaching members 410 are tightened to this torque, the attaching members 410 are further tightened to a next incremental torque and so on until the attaching members 410 are fully tightened. Additionally, each clamping member 402a, 402b should be tightened down in parallel with the other, so that substantially equal force is placed on each side of the card 406 during and after tightening.

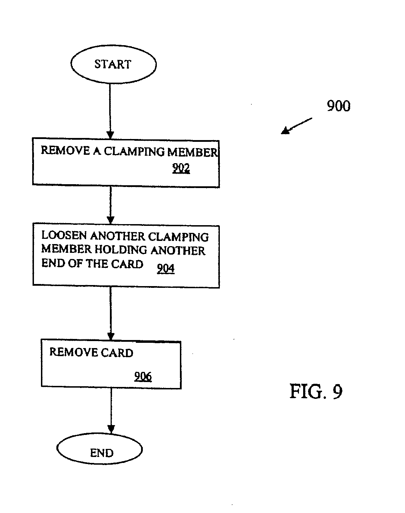

With embodiments of the present invention, the card 406 can be removed in a relatively simple fashion. For example, please refer to the flow diagram 900 of Figure 9. In Figure 9, an example of one method of removing a card 410 from the guide 400 of the present invention is shown. A first clamping member is loosened from one side of the card 406 (902). This is done by loosening the attaching members 410 attaching the clamping member to the card 406. A second clamping member holding the card 406 at another end of the card is then loosened (904). This is done by loosening the respective attaching members (410). The card 406 is then removed from the guide 400 (906). Accordingly, with this method, only a first and second clamping member need be loosened to remove a card. In other embodiments, one or more clamping members are fully removed to the remove a card 406.

Although specific embodiments have been illustrated and described herein, it will be appreciated by those of ordinary skill in the art that any arrangement, which is calculated to achieve the same purpose, may be substituted for the specific embodiment shown. This application is intended to cover any adaptations or variations of the present invention. Therefore, it is manifestly intended that this invention be limited only by the claims and the equivalents thereof.

## Claims

1. An electronic card heat transferring guide 400, the system comprising:
at least one first clamping member 402a, each first clamping member 402a having at least one clamping aperture 512, each first clamping member 402a having a first surface 520 adapted to abut an inside surface 516 of a chassis wall 530, each first clamping member 402a having a second surface 522 adapted to abut an electronic card 406;
at least one second clamping member 402b, each second clamping member 402b having at least one clamping aperture 512, each second clamping member 402b having a first surface 524 adapted to abut the inside surface 516 of the chassis wall 530, each second clamping member 402b having a second surface 526 adapted to abut the electronic card 406; and
a plurality of attaching members 410, each attaching member 410 adapted to engage an associated first and second clamping member 402a and 402b through the chassis wall 530 via associated clamping apertures 512 in the respective first and second clamping members 402a and 402b, wherein tightening each respective attaching member 410 draws the second surface 522 and 526 of the first and second clamping members 402a and 402b to abut the electronic card 406 and the inside surface 516 of the wall 530 thereby securing the electronic card 406 between the first and second clamping members 402a and 402b in the chassis and providing a relatively efficient thermal conduit between the electronic card 406 and the chassis.

2. The electronic card heat transferring guide 400 of claim 1, wherein the first surface 520 and 524 of each first and second clamping member 402a and 402b adjoins the second surface 522 and 526 of the respective first and second clamping member 402a and 402b at a 290° angle.

3. The electronic card heat transferring guide 400 of claim 1.
at least one securing bar 404, each securing bar 404 having a plurality of the securing apertures 507 passing there through, each securing bar 404 adapted to abut an outside surface 515 of a chassis 530, each attaching member 410 adapted to pass through an associated securing aperture 507.

4. The electronic card heat transferring guide 400 of claim 3, wherein the securing bar 404 further includes a counter bore 511 about each securing aperture 507.

5. The electronic card heat transferring guide 400 of claim 3, wherein each securing aperture 507 is at a select angle through its respective securing bar 404.

6. The electronic card heat transferring guide 400 of claim 5, wherein the select angle of each securing aperture 507 is 45°.

7. The electronic card heat transferring guide 400 of claim 1, wherein each clamping aperture 512 is at a select angle through its respective clamping member 402a and 402b.

8. The electronic card heat transferring guide 400 of claim 7, wherein the select angle of each clamping aperture 512 is 45°.

9. The electronic card heat transferring guide 400 of claim 1, wherein each clamping aperture 512 has internal threads.

10. The electronic card heat transferring guide 400 of claim 9, wherein each attaching member 410 has external threads adapted to threadably engage associated internal threads in a respective clamping aperture 512.
